(19) Europäisches Patentamt
European Patent Office
Office européen des brevets

(11) **EP 1 342 132 B1**

(12) **FASCICULE DE BREVET EUROPEEN**

(45) Date de publication et mention
de la délivrance du brevet:
**10.11.2010 Bulletin 2010/45**

(21) Numéro de dépôt: **00977337.5**

(22) Date de dépôt: **05.12.2000**

(51) Int Cl.:
*G04G 13/02* ^(2006.01)    *H02K 33/16* ^(2006.01)

(86) Numéro de dépôt international:
**PCT/CH2000/000645**

(87) Numéro de publication internationale:
**WO 2002/046847 (13.06.2002 Gazette 2002/24)**

(54) **PROCEDE D'ENTRETIEN DES OSCILLATIONS D'UN DISPOSITIF VIBRANT ET DISPOSITIF VIBRANT METTANT EN OEUVRE CE PROCEDE**

VERFAHREN ZUM INSTANDHALTEN DER OSZILLATION EINER VIBRIERENDEN VORRICHTUNG UND VIBRIERENDE VORRICHTUNG DIE DIESES VERFAHREN ANWENDET

METHOD FOR MAINTAINING OSCILLATIONS OF A VIBRATING DEVICE AND VIBRATING DEVICE USING SAME

(84) Etats contractants désignés:
**CH DE FR GB LI**

(43) Date de publication de la demande:
**10.09.2003 Bulletin 2003/37**

(73) Titulaire: **ETA SA Manufacture Horlogère Suisse CH-2540 Grenchen (Canton de Soleure) (CH)**

(72) Inventeurs:
• **ROTA, Sergio**
  **CH-2000 Neuchâtel (CH)**
• **KÜNZI, Stéphane**
  **CH-2036 Cormondrèche (CH)**

(74) Mandataire: **Ravenel, Thierry Gérard Louis et al ICB**
  **Ingénieurs Conseils en Brevets SA**
  **Faubourg de l'Hôpital 3**
  **2001 Neuchâtel (CH)**

(56) Documents cités:
**EP-A- 0 938 034     DE-A- 19 859 622**
**US-A- 5 436 622     US-A- 5 736 797**
**US-A- 5 955 799**

EP 1 342 132 B1

## Description

La présente invention se rapporte de manière générale à des dispositifs vibrants et autres alarmes non sonores destinés à équiper une unité portée près du corps, tel que notamment une pièce d'horlogerie. Plus spécifiquement, la présente invention se rapporte à un procédé d'entretien des oscillations d'un dispositif vibrant ainsi qu'à un dispositif vibrant mettant en oeuvre ce procédé.

Dans de nombreuses situations, il est utile de pouvoir transmettre une information à une personne autrement que par des moyens sonores ou visuels. C'est le cas notamment lorsque l'on souhaite prévenir de façon discrète une personne qui se trouve au milieu d'une assemblée. Des moyens tactiles de transmission de l'information offrent à cet effet une alternative intéressante : il s'agit de mettre en vibration une unité que la personne porte près du corps, telle qu'une montre par exemple, afin de stimuler localement son épiderme pour lui indiquer une heure donnée ou l'occurrence d'un événement (arrivée d'un message, d'un appel, d'un rendez-vous, etc.). De tels moyens tactiles de transmission de l'information trouvent notamment une application dans un dispositif permettant d'indiquer à des personnes, dont l'acuité visuelle est réduite ou inexistante, l'heure, l'occurrence d'une alarme, ou tout autre événement. A titre d'information, on pourra se référer aux demandes de brevet européen EP 0 710 899 et EP 0 884 663, toutes deux également au nom de la Demanderesse, qui décrivent des pièces d'horlogerie incorporant un dispositif vibrant.

Des dispositifs de mise en vibration du type à balourd monté sur un rotor sont connus de l'homme du métier. Dans ces dispositifs, typiquement, le balourd tourne à une vitesse de quelques dizaines de tours par secondes grâce à un moteur électrique alimenté avec une puissance de quelques dizaines de milliwatts et enclenché à l'instant où l'occurrence d'un événement doit être perçue par le porteur.

Ces dispositifs présentent comme inconvénient principal de consommer beaucoup d'énergie, ce qui est peu compatible avec des exigences de miniaturisation des piles et des composants telles qu'on peut les rencontrer dans le domaine horloger.

La demande de brevet européen EP 0 625 738 au nom de la Demanderesse décrit un dispositif de mise en vibration d'une unité telle qu'une montre. Ce dispositif comprend une bobine couplée électromagnétiquement avec une masse mobile.

Cette demande de brevet ne décrit pas les caractéristiques des moyens d'excitation de la bobine. Cela dit, l'homme du métier sait qu'il faut appliquer à la bobine des impulsions dont la fréquence est égale à la fréquence propre d'oscillation mécanique de la masse mobile afin d'obtenir une amplitude de vibration maximale pour une quantité d'énergie fournie donnée.

Or, il se trouve qu'en pratique cette fréquence propre est difficile à déterminer rigoureusement. Tout d'abord, elle varie d'une masse mobile à l'autre en raison des tolérances de fabrication, qui sont de l'ordre de 15%. Ensuite, elle varie en fonction de la manière dont l'ensemble bobine-masse mobile est porté, et fait plus ou moins corps avec le porteur. Typiquement, les conditions au porter induisent des variations de l'ordre de 5% de la fréquence propre de l'ensemble, ainsi qu'une variation de l'énergie dissipée. Ces variations diminuent le rendement des moyens d'excitation conçus pour fonctionner à fréquence fixe, et il en résulte une importante déperdition d'énergie.

La présente invention a pour but général de remédier à ces inconvénients.

On notera que l'homme du métier connaît déjà du document US 5,436,622 un dispositif vibrant comprenant un ensemble bobine-masse mobile qui est actionné, dans une première phase, à une fréquence sensiblement égale à une fréquence propre d'oscillation nominale de la masse mobile, puis, dans une deuxième phase, est laissé en oscillation libre afin de déterminer la fréquence propre d'oscillation de l'ensemble qui dépend des conditions de porter du dispositif par l'utilisateur. Une fois la fréquence propre d'oscillation déterminée, la masse mobile est entraînée à cette fréquence pour toute la durée restante de la vibration.

Selon ce document, on notera que le dispositif vibrant est mis en vibration par un signal rectangulaire périodique de fréquence égale à la fréquence propre d'oscillation déterminée, et ceci durant toute la durée de mise en vibration de la masse mobile. Ce fait ressort par exemple clairement de la figure 3 du document US 5,436,622. Selon ce document, le dispositif vibrant est ainsi entraîné en continu et n'est jamais laissé en oscillation libre durant la période de mise en vibration du dispositif.

Etant donné que la fréquence propre d'oscillation de l'ensemble est dépendante des conditions de porter, cette fréquence peut varier sensiblement durant la période de mise en vibration du dispositif. Ainsi, un inconvénient majeur du dispositif décrit dans le document US 5,436,622 susmentionné réside dans le fait qu'il ne peut répondre à une modification de la fréquence propre d'oscillation durant la mise en vibration du dispositif vibrant, la mesure n'étant effectué que lors d'une activation suivante du dispositif. Le rendement énergétique de ce dispositif n'est ainsi pas optimal, de sorte qu'une solution alternative doit être recherchée. Selon ce document US 5,436,622, il est notamment suggéré d'équiper le dispositif vibrant d'un capteur additionnel permettant de mesurer la fréquence de l'oscillation, comme cela ressort de la figure 5 de ce document, afin de permettre une adaptation de la fréquence d'oscillation du dispositif vibrant durant l'oscillation en cours.

La demande de brevet européen EP 0 938 034, au nom de la Demanderesse, décrit une solution avantageuse selon laquelle la fréquence propre d'oscillation du dispositif vibrant est déterminée à chaque période (ou demi-période) d'oscillation de la masse mobile. Au contraire de la solution décrite dans le brevet US susmentionné, cette solution permet ainsi de prendre en compte les variations de la fréquence propre de résonance durant la mise en vibration du dispositif, et ceci sans qu'il soit nécessaire d'utiliser un capteur additionnel. Ici, le dispositif est entraîné en vibration, non pas par un signal rectangulaire périodique de fréquence déterminée, mais par une succession d'impulsions positives et négatives générées à chaque demi-période d'oscillation après des intervalles de temps qui sont fonction de la fréquence instantanée d'oscillation de la masse mobile mesurée lors de la période précédente. Entre les impulsions d'entretien, le dispositif oscille librement de sorte qu'une mesure de la fréquence propre instantanée est possible.

La Demanderesse a pu constater que cette solution pouvait présenter un inconvénient dans certaines conditions. Sans moyens de contrôle adéquats, cette solution peut notamment être sujette à des erreurs de mesure qui auront pour conséquence un entraînement du vibreur à une fréquence inadéquate. En effet, dans l'éventualité où une erreur de mesure surgit, cette erreur de mesure se répète alors durant les oscillations suivantes, de sorte que le dispositif devient rapidement instable. Pour s'affranchir de ce risque, il convient alors de concevoir le dispositif de sorte qu'une telle instabilité soit empêchée.

Une solution à ce problème peut consister à alterner les périodes de mesure de la fréquence propre d'oscillation et les périodes d'entretien des oscillations du dispositif vibrant afin de laisser ce dernier vibrer librement et permettre une mesure fidèle de la fréquence propre d'oscillation. Cette solution n'est toutefois pas appropriée du fait de l'amortissement rapide des oscillations, amortissement qui implique la génération d'une impulsion d'entretien de plus forte intensité pour maintenir l'oscillation de l'ensemble et qui engendre en conséquence une consommation plus élevée.

La présente invention a ainsi pour autre but de proposer une solution alternative à celle décrite notamment dans le document EP 0 938 034 qui permette de répondre de manière adéquate aux variations de la fréquence propre d'oscillation du dispositif et qui reste aisée à mettre en oeuvre.

La présente invention a également pour but de proposer une solution qui est plus robuste et plus stable que les solutions de l'art intérieur.

La présente invention a ainsi pour objet un procédé d'entraînement d'un dispositif vibrant destiné à équiper une unité portée près du corps conforme aux caractéristiques de la revendication indépendante 1.

Des modes de mise en oeuvre avantageux de ce procédé font l'objet des revendications dépendantes.

La présente invention a également pour objet un dispositif vibrant destiné à équiper une unité portée près du corps conforme aux caractéristiques de la revendication indépendante 4.

Des modes de réalisation avantageux de ce dispositif vibrant font l'objet des revendications dépendantes.

Selon l'invention, la fréquence propre de résonance du dispositif vibrant est ainsi déterminée une fois pour toute au début de son activation. Les impulsions d'entretien sont générées après un intervalle de temps déterminé et non-variable qui est notamment dépendant de la mesure effectuée en début d'activation et qui est considéré à partir du passage par le niveau moyen de la tension induite de mouvement produite aux bornes de la bobine. Cet intervalle de temps non-variable peut être prédéterminé et ne nécessite pas obligatoirement une mesure préalable de la fréquence propre d'oscillation du dispositif. Ainsi, bien que l'intervalle de temps entre le passage par le niveau moyen de la tension induite de mouvement et la génération de l'impulsion d'entretien suivante soit fixe, une adaptation de la fréquence à laquelle sont générées les impulsions d'entretien est néanmoins opérée de part le fait que le temps pris par la tension induite pour atteindre son niveau moyen après la génération d'une impulsion d'entretien est fonction de la fréquence propre instantanée d'oscillation. On notera que la tension induite de mouvement est l'image de la vitesse de la masse mobile dont la fréquence d'oscillation correspond à la fréquence propre d'oscillation mécanique de la masse mobile.

D'autre part, cette solution est plus robuste que la solution préconisée dans le document EP 0 938 034 susmentionné, en ce sens que le dispositif n'est pas sensible à une erreur de mesure de la fréquence propre lors de la période d'oscillation précédente pouvant engendrer une instabilité du dispositif. En effet, la fréquence propre d'oscillation est mesurée une fois pour toute au début de la mise en vibration du dispositif et cette fréquence propre d'oscillation détermine l'intervalle de temps à partir du passage par le niveau moyen de la tension induite de mouvement au terme duquel l'impulsion d'entretien est générée.

Selon la présente invention, on comprendra qu'un compromis est ainsi réalisé. En effet, bien que la fréquence propre d'oscillation soit mesurée une fois pour toute au début de la mise en vibration du dispositif, des variations de la fréquence dues aux conditions variables de porter sont néanmoins prises en compte, dans une certaine mesure, de par le fait que chaque impulsion d'entretien est généré au terme d'un intervalle de temps déterminé considéré à partir du passage par le niveau moyen de la tension induite de mouvement produite aux bornes de la bobine. Il existe ainsi une relation intime entre la tension induite produite aux bornes de la bobine et la génération des impulsions d'entretien. Les impulsions d'entretien interviendront légèrement plus tôt ou plus tard selon les conditions de porter, mais n'interviendront en aucun cas à des moments inappropriés et pouvant engendrer une instabilité du système.

D'autres caractéristiques et avantages de la présente invention apparaîtront plus clairement à la lecture de la description détaillée qui suit, faite en référence aux dessins annexés donnés à titre d'exemples non limitatifs et dans lesquels :

- la figure 1 montre un schéma bloc d'un circuit d'entraînement du dispositif vibrant permettant de mettre en oeuvre le procédé d'entraînement selon la présente invention;
- la figure 2 montre un diagramme de l'évolution en fonction du temps de la tension induite de mouvement $U_{ind}$ aux bornes de la bobine et un diagramme illustrant l'allure des impulsions d'entretien générées au cours du temps; et
- la figure 3 montre un diagramme illustrant les diverses phases effectuées au cours du temps lors du démarrage du dispositif vibrant selon le mode de mise en oeuvre de la présente invention;
- les figures 4A à 4C montrent respectivement des premier, deuxième et troisième diagramme de l'évolution en fonction du temps de la tension $V_{B12}$ présente aux bornes de la bobine pour des fréquences respectivement égale, supérieure et inférieure à une fréquence d'oscillation nominale $f_O$; et
- la figure 5 illustre un exemple de mise en oeuvre d'un principe permettant de filtrer des surtensions apparaissant au terme de chaque impulsion d'entretien.

Dans un mode de réalisation préféré, le dispositif selon l'invention comporte des organes de structure analogues à ceux décrits dans la demande de brevet européen EP 0 625 738 susmentionnée. Il comporte ainsi un boîtier (non représenté), une masse mobile (non représentée) à l'intérieur de ce boîtier destinée à lui transmettre des vibrations et une bobine couplée électromagnétiquement à cette masse mobile.

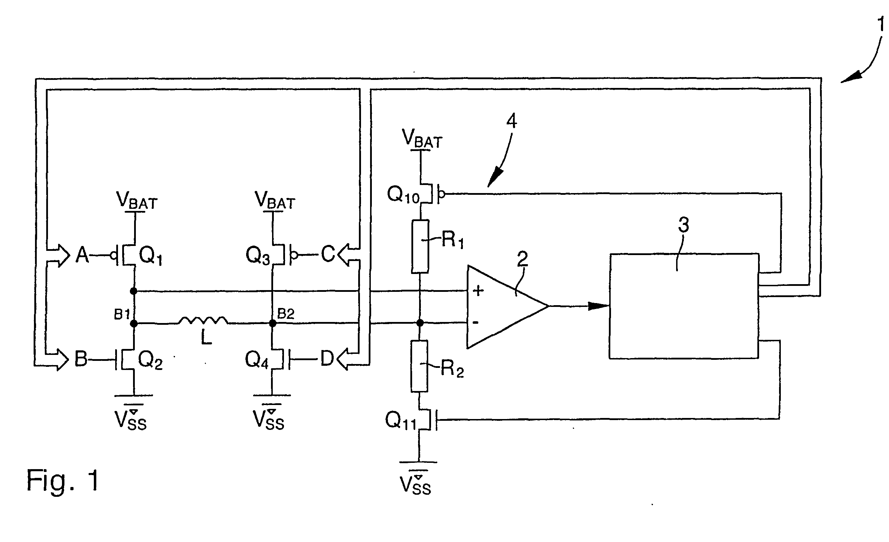

Cette bobine est représentée schématiquement sur la figure 1 et est indiquée par la référence L. Ses première B1 et deuxième B2 bornes sont susceptibles d'être portées à une tension nulle (masse $V_{SS}$) ou à une tension $V_{BAT}$ selon les états de quatre transistors Q1, Q2, Q3, Q4.

Les quatre transistors Q1, Q2, Q3, Q4 forment un pont en H permettant de commander le dispositif vibrant en mode bipolaire. Le pont en H comprend ainsi une première et une seconde branche comprenant les transistors Q1 et Q2, respectivement les transistors Q3 et Q4, montés en série entre les tensions $V_{BAT}$ et $V_{SS}$. Plus spécifiquement, les transistors Q1 et Q3 sont des transistors MOS de type p, et les transistors Q2 et Q4 des transistors MOS de type n. Comme on peut le voir de la figure 1, la première borne B1 de la bobine est connecté au noeud de connexion des transistors Q1 et Q2, et la deuxième borne B2 au noeud de connexion des transistors Q3 et Q4.

Les grilles des transistors Q1, Q2, Q3 et Q4 sont respectivement commandés par des signaux A, B, C et D produits par un circuit logique 3. En fonction des signaux de commande A, B, C et D, les transistors Q1, Q2, Q3, Q4 et la bobine L occupent les états indiqués par la table de vérité suivante où les indications "NC" et "C" signifient respectivement que le transistor considéré est à l'état non-conducteur ou conducteur :

| A | B | C | D | Q1 | Q2 | Q3 | Q4 | Bobine L |
|---|---|---|---|----|----|----|----|----------|
| 1 | 0 | 1 | 0 | NC | NC | NC | NC | haute impédance |
| 0 | 0 | 1 | 1 | C | NC | NC | C | B1=$V_{BAT}$; B2=$V_{SS}$ |
| 1 | 1 | 0 | 0 | NC | C | C | NC | B1=$V_{SS}$; B2=$V_{BAT}$ |
| 0 | 0 | 0 | 0 | C | NC | C | NC | court-circuit |

Les première et deuxième bornes B1, B2 de la bobine L sont par ailleurs respectivement reliées aux bornes non-inverseuse (borne positive) et inverseuse (borne négative) d'un comparateur 2 constitué d'un amplificateur différentiel chargé d'amplifier et de restituer en sortie la tension induite de mouvement $U_{ind}$ mesurée entre les bornes B1, B2 de la bobine L. Cette tension induite de mouvement $U_{ind}$ est appliquée à l'entrée du circuit logique 3 chargé, d'une part, de générer les signaux de commande A, B, C, D nécessaires aux transistors Q1, Q2, Q3, Q4 du pont en H pour assurer la génération des impulsions de démarrage et des impulsions d'entretien des vibrations du dispositif vibrant, et, d'autre part, de mesurer la fréquence de la tension induite UIND issue du comparateur 2.

On ne s'attardera pas longuement sur la réalisation du circuit logique 3. L'homme du métier pourra se référer à la demande européenne EP 0 938 034 déjà mentionnée, qui est incorporée ici par référence, pour obtenir les informations nécessaire lui permettant de réaliser concrètement le dispositif selon la présente invention sur la base des indications qui lui sont fournies ci-après.

Comme illustré dans la figure 1, le dispositif comprend par ailleurs avantageusement un diviseur de tension enclenchable, désigné globalement par la référence numérique 4 chargé d'imposer une tension déterminée sur l'entrée inverseuse (entrée négative) du comparateur 2. Ce diviseur de tension 4, ici sous la forme d'un diviseur résistif, forme un moyen permettant de fixer l'entrée négative du comparateur 2 à un potentiel déterminé, uniquement lorsque la tension induite de mouvement $U_{ind}$ est observée, c'est-à-dire entre deux impulsions d'entretien successives, lorsque la bobine L est dans l'état haut-impédance (Q1, Q2, Q3, Q4 à l'état non conducteur). Ce diviseur résistif est déclenché dans les autres phases.

Plus spécifiquement, le diviseur résistif 4 comprenant un agencement en série entre les tensions $V_{BAT}$ et $V_{SS}$.

d'un premier transistor Q10 (transistor MOS de type p), de première et seconde résistances $R_1$, $R_2$, et d'un second transistor Q11 (transistor MOS de type n). Le noeud de connexion entre les résistances $R_1$ et $R_2$ est reliée à l'entrée inverseuse du comparateur 2 et les grilles des transistors Q10 et Q11 sont connectées au circuit logique 3.

Dans cet exemple de réalisation, on choisit par exemple de fixer le potentiel de la borne inverseuse du comparateur 2 à une tension égale à $V_{BAT}/2$ en utilisant pour ce faire des résistances $R_1$ et $R_2$ de valeurs sensiblement égales. Lorsque la bobine L est à l'état haute impédance, c'est-à-dire lorsque les transistors Q1, Q2, Q3 et Q4 du pont en H sont tous à l'état non-conducteur, le diviseur résistif 4 est ainsi enclenché par l'activation des transistors Q10 et Q11 et une tension sensiblement égale à $V_{BAT}/2$ est appliquée à l'entrée inverseuse du comparateur 2. De la sorte, la valeur moyenne de la tension induite est fixée à ce niveau $V_{BAT}/2$.

Le niveau $V_{BAT}/2$ sera notamment utilisé par le circuit logique 3 dans l'optique de détecter les moments dans le temps à partir desquels les impulsions d'entretien doivent être générées. En référençant la tension induite de mouvement $U_{ind}$ par rapport au niveau $V_{BAT}/2$, on assure également que la tension induite de mouvement $U_{ind}$ est toujours positive, son amplitude crête à crête étant inférieure à la tension $V_{BAT}$. Dans l'exemple de réalisation qui est décrit dans la présente demande, on comprendra que la tension induite de mouvement $U_{ind}$ est échantillonnée à une fréquence déterminée. En fixant la valeur moyenne de la tension induite de mouvement $U_{ind}$ à ce niveau $V_{BAT}/2$, tous les échantillons du signal sont ainsi positifs.

On comprendra aisément, que l'utilisation du diviseur résistif n'est pas strictement nécessaire. On comprendra également qu'un autre niveau moyen que $V_{BAT}/2$ pourrait être fixé par le diviseur résistif 4. L'exemple qui est présenté ici est particulièrement avantageux dans l'optique où il est désirable d'effectuer un traitement digital du signal produit en sortie du comparateur.

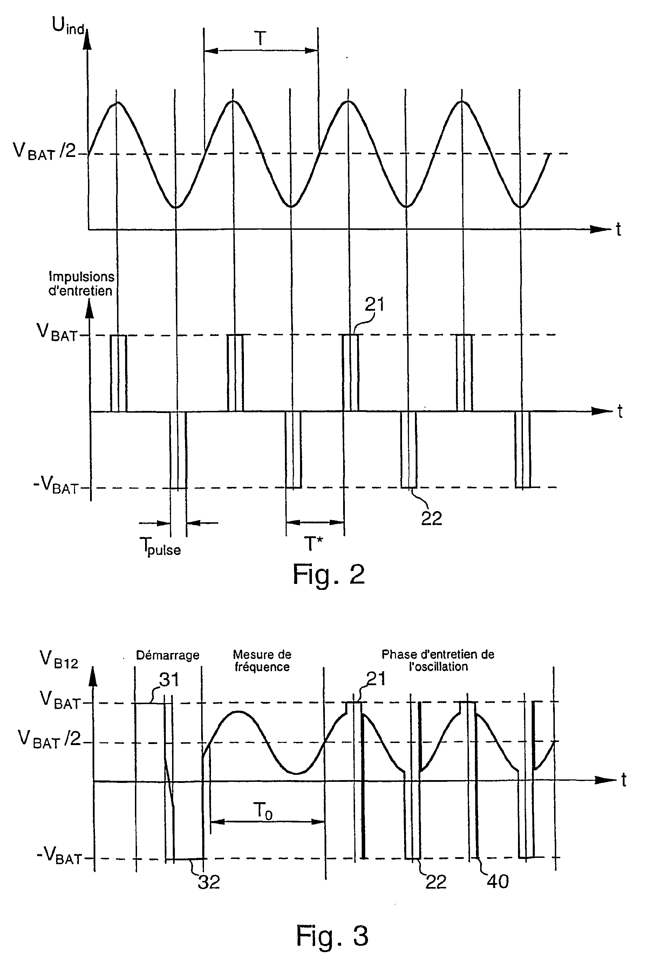

La figure 2 montre schématiquement deux diagrammes, respectivement, de la tension induite de mouvement $U_{ind}$ et de l'allure des impulsions d'entretien générées en fonction du temps. Comme mentionné plus haut, la valeur moyenne de la tension induite de mouvement $U_{ind}$ est fixée au niveau $V_{BAT}/2$. Cette tension induite a une période T (ou en termes équivalents une fréquence f) qui est en partie déterminée par les conditions au porter de l'objet dans lequel est incorporé le dispositif vibrant. La fréquence f de ce signal correspond essentiellement à la fréquence mécanique de résonance du dispositif vibrant.

Comme on peut le voir sur la figure 2, les impulsions d'entretien sont générées en phase avec la tension induite de mouvement. Des impulsions d'entretien de polarité positive et négative 21, 22 se succèdent ainsi alternativement dans le temps. Plus spécifiquement, les impulsions d'entretien sont générées sensiblement en phase avec les extrema de la tension induite de mouvement $U_{ind}$. Du point de vue énergétique, il est en effet préférablement de générer ces impulsions d'entretien lorsque l'amplitude de mouvement de la masse mobile est nulle, c'est-à-dire lorsque l'amplitude de la tension induite de mouvement $U_{ind}$ est maximale. On comprendra aisément que le bilan énergétique est nettement moins bon si les impulsions d'entretien sont générées à d'autres moments. On comprendra donc qu'il existe une relation intime entre la tension induite de mouvement $U_{ind}$ et la génération des impulsions d'entretien.

En se référant au diagramme de la figure 2 illustrant l'allure des impulsions d'entretien on notera que l'intervalle de temps $T^*$ qui sépare deux impulsions d'entretien successives déterminera sensiblement la fréquence à laquelle le dispositif vibrant est entraîné. La largeur des impulsions $T_{pulse}$ détermine de son côté l'intensité de la vibration générée. On comprendra aisément que plus les impulsions sont larges, plus l'intensité de la vibration sera élevée. Comme on le comprendra aisément, la largeur des impulsions est toutefois limitée de manière à permettre une oscillation libre de l'ensemble entre deux impulsions d'entretien successives et permettre une adaptation de la fréquence de vibration durant le fonctionnement du dispositif vibrant.

Dans le cadre de la présente invention, on notera tout d'abord que l'intervalle de temps $T^*$ entre deux impulsions d'entretien successives est adapté à la fréquence instantanée d'oscillation de l'ensemble qui ressort de l'allure de la tension induite de mouvement $U_{ind}$. Il convient à nouveau de préciser que le dispositif décrit dans la demande européenne EP 0 938 034 déjà mentionnée fonctionne sur un principe similaire mais toutefois différent en ce sens que l'intervalle de temps entre deux impulsions est, selon cette demande européenne, ajusté exactement à la période d'oscillation mesurée lors de la période (ou demi-période) d'oscillation précédente à partir de la tension induite de mouvement $U_{ind}$. Selon cette demande européenne, l'intervalle de temps $T^*$ entre deux impulsions d'entretien successives correspond sensiblement à la demi-période d'oscillation de la tension induite de mouvement $U_{ind}$ mesurée lors de la période précédente.

Au contraire, dans le cadre de la présente invention, la mesure est effectuée une fois pour toute lors de la mise en vibration du dispositif de sorte que l'intervalle de temps $T^*$ séparant deux impulsions d'entretien successives ne sera pas exactement ajusté à la période instantanée d'oscillation du dispositif. Par extension, cette mesure n'est a priori pas nécessaire et les paramètres temporels définissant quand doivent être générées les impulsions d'entretien peuvent être fixés au préalable sur la base d'une fréquence d'oscillation typique ou nominale.

Selon la présente invention, comme on le verra clairement plus loin, cet intervalle de temps $T^*$ varie malgré tout en fonction de la fréquence instantanée d'oscillation sans qu'il ne soit nécessaire d'effectuer une mesure exacte de cette fréquence à chaque période d'oscillation. On évite de la sorte des problèmes potentiels liés à une erreur de mesure de la fréquence instantanée d'oscillation étant donné que cette mesure n'est effectuée qu'une seule fois lors de la mise en route du dispositif vibrant ou déterminée préalablement, problèmes qui peuvent éventuellement surgir avec un dispositif vibrant fonctionnant sur la base du principe décrit dans la demande EP 0 938 034 susmentionnée.

La figure 3 illustre schématiquement la mise en route du dispositif vibrant selon le mode de mise en oeuvre de la présente invention. Plus spécifiquement, la figure 3 montre un diagramme de l'évolution de la tension $V_{B12}$ aux bornes de la bobine L en fonction du temps au moment de la mise en route du dispositif vibrant. Dans une première phase, dite phase de démarrage, deux impulsions de démarrage 31, 32 de polarité inverse sont successivement générées afin de mettre en vibration le dispositif.

Cette première phase est suivie d'une seconde phase, dite phase de mesure de fréquence, durant laquelle le dispositif est laissé en oscillation libre. Durant cette seconde phase, le dispositif tendra à osciller selon sa fréquence propre d'oscillation, ci-après dénommée fréquence d'oscillation nominale et référée par la référence $f_O$. Cette fréquence nominale $f_O$ est par exemple mesurée en déterminant la période d'oscillation $T_O$, dite période nominale, de la tension induite de mouvement durant cette seconde phase sur la base des passages par le niveau moyen de la tension induite de mouvement. Alternativement, on peut se contenter de mesurer la demi-période d'oscillation du signal. Comme déjà mentionné, cette seconde phase de mesure n'est pas strictement nécessaire car la période nominale $T_O$ peut être fixée au préalable.

Une fois la période nominale $T_O$ déterminée ou fixée, le dispositif entre dans une troisième phase, dite phase d'entretien, qui se prolonge jusqu'au terme de la mise en vibration du dispositif. Durant cette troisième phase, les impulsions d'entretien 21, 22 de polarité alternée, sensiblement en phase avec les extrema de la tension induite de mouvement, sont générées conformément au principe qui a été présenté en référence à la figure 2.

Durant la phase d'entretien, au terme de chaque impulsion d'entretien appliquée à la bobine L du dispositif vibrant, on notera que le blocage simultané des quatre transistors Q1, Q2, Q3 et Q4 du pont en H a pour conséquence l'apparition d'une surtension de polarité opposée, repérée 40, dont la constante de temps est dépendante des caractéristique de la bobine L, notamment de sa résistance électrique et de son inductance. On reviendra ultérieurement sur la question de ces surtensions.

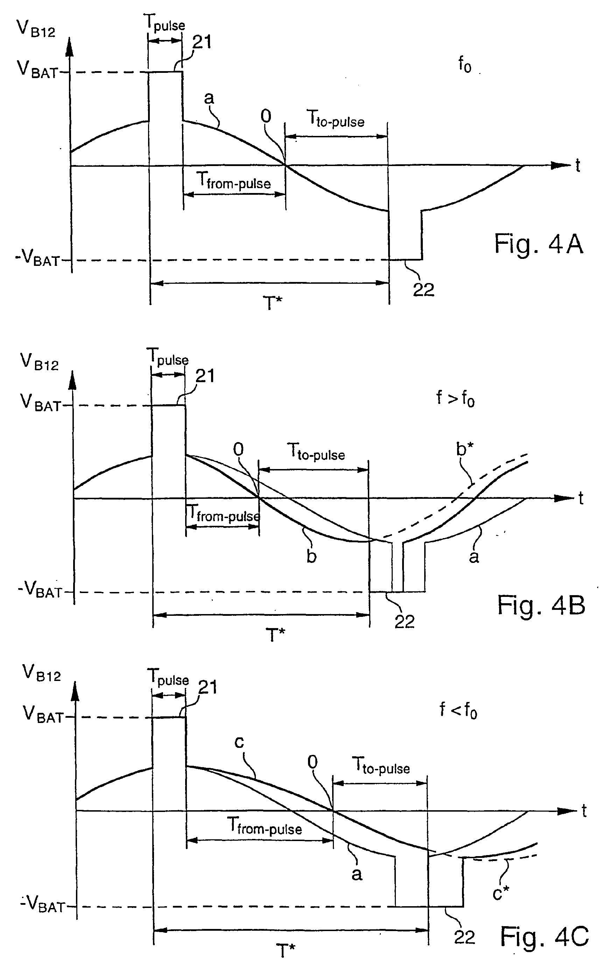

En référence aux figures 4A à 4C, on va maintenant décrire en détail le principe d'entraînement du dispositif vibrant selon la présente invention. Par souci de simplification, on notera que les surtensions qui viennent d'être mentionnées n'ont pas été représentées dans ces figures. Egalement par souci de simplification, on a représenté le tension $V_{B12}$ aux bornes de la bobine comme ayant une valeur moyenne nulle et non une valeur moyenne égale au niveau $V_{BAT}/2$ imposé par le diviseur résistif 4. Dans le principe, ceci ne change fondamentalement rien.

Les figures 4A, 4B et 4C montrent chacune l'évolution, en fonction du temps, de la tension $V_{B12}$ aux bornes de la bobine L durant la phase d'entretien, c'est-à-dire la troisième et dernière phase illustrée dans la figure 3. Plus spécifiquement, la figure 4A montre l'évolution, indiquée par la courbe a, de la tension $V_{B12}$ dans un cas où la fréquence propre d'oscillation du dispositif vibrant correspond sensiblement à la fréquence nominale $f_O$ qui était celle du dispositif vibrant lors de la phase de mesure de fréquence (seconde phase dans la figure 3), c'est-à-dire dans une situation où la fréquence propre d'oscillation du dispositif vibrant n'aurait pas été modifiée par les conditions au porter de l'utilisateur.

Dans ce cas de figure, étant donné qu'il n'y aucune modification de la fréquence, la durée T* séparant deux impulsions d'entretien successives 21, 22 est sensiblement égale à la moitié de la période nominal $T_O$ mesurée ou fixée, c'est-à-dire $T_O/2$, et le dispositif vibrant est ainsi entraîné à une fréquence sensiblement égale à la fréquence nominale $f_O$ mesurée.

Selon la présente invention, chaque impulsion d'entretien, qu'elle soit de polarité positive ou négative, est généré au terme d'un intervalle de temps déterminé, désigné $T_{to\text{-}pulse}$, qui est considéré à partir du passage par le niveau moyen de la tension $V_{B12}$ qui est indiquée par la référence O dans les figures (dans ce cas, il s'agit du passage par zéro de la tension $V_{B12}$). Cet intervalle de temps $T_{to\text{-}pulse}$ est fixé une fois pour toute par la détermination de la période nominale $T_O$. Plus spécifiquement, cet intervalle de temps $T_{to\text{-}pulse}$ vaut le quart de la période nominale $T_O$ auquel on déduit la moitié de la largeur d'impulsion $T_{pulse}$, c'est-à-dire :

$$T_{to\text{-}pulse} = T_O/4 - T_{pulse}/2 \qquad\qquad (1)$$

On comprendra que l'intervalle de temps T* séparant deux impulsions d'entretien successives 21, 22 est en partie déterminé par l'intervalle de temps $T_{to\text{-}pulse}$. L'intervalle de temps T* est en outre déterminé par le temps pris par la masse mobile pour retrouver sa position médiane (ou de repos) par rapport à la bobine, c'est-à-dire, en d'autres termes, le temps pris par la tension induite de mouvement pour retomber à une amplitude (par rapport à sa valeur moyenne) qui est nulle. Dans les figures, ce temps est indiqué par la référence $T_{from\text{-}pulse}$. En conséquence, on comprendra que l'intervalle de temps T* entre deux impulsions est dépendant de deux facteurs, l'un étant un intervalle de temps déterminé et non variable, $T_{to\text{-}pulse}$, et l'autre étant un intervalle de temps variable, $T_{from\text{-}pulse}$, dépendant des

conditions de porter du dispositif vibrant.

Selon la présente invention, on constatera ainsi que, bien que la mesure de fréquence n'ait lieu qu'une fois lors de la mise en route du dispositif vibrant (ou qu'elle soit alternativement fixée au préalable), la fréquence à laquelle sont générées les impulsions d'entretien varie néanmoins en fonction de la fréquence instantanée d'oscillation du dispositif vibrant. Ceci apparaîtra clairement de la discussion des figures 4B et 4C.

La figure 4B illustre un autre cas de figure dans lequel une variation des conditions au porter du dispositif vibrant a conduit à une augmentation de la fréquence d'oscillation par rapport à la fréquence nominale $f_O$. Il en résulte une modification de la fréquence de la tension induite de mouvement et donc de la tension $V_{B12}$ aux bornes de la bobine. Cette modification est illustré schématiquement par la courbe b dans la figure 4B. A titre de comparaison, la courbe a de la figure 4A est également reportée sur la figure 4B.

Dans la situation illustrée à la figure 4B, on comprendra donc que le temps $T_{from-pulse}$ pris par la tension induite de mouvement pour retomber à une amplitude nulle par rapport à sa valeur moyenne est en conséquence réduit par rapport à la situation illustrée à la figure 4A. L'intervalle de temps $T_{to-pulse}$ au terme duquel l'impulsion d'entretien suivante est générée restant fixe, l'impulsion d'entretien (22 dans la figure) est appliquée avec une légère erreur de phase (en retard) par rapport à l'extrema de la tension induite de mouvement comme on peut le constater en comparant la position dans le temps de l'impulsion d'entretien 22 par rapport à la courbe b* qui illustre l'évolution de la tension induite de mouvement dans l'éventualité où aucune impulsion n'est générée. Du point de vue énergétique, on constatera néanmoins que le bilan énergétique est meilleur que dans le cas où les impulsions d'entretien sont générées périodiquement à des intervalles de temps fixes comme dans les solutions de l'art antérieur.

La figure 4C illustre le cas de figure opposé dans lequel une variation des conditions au porter du dispositif vibrant a conduit à une réduction de la fréquence d'oscillation par rapport à la fréquence nominale $f_O$. Il en résulte également une modification de la fréquence de la tension induite de mouvement et donc de la tension $V_{B12}$ aux bornes de la bobine qui est illustré schématiquement par la courbe c dans la figure 4C. A titre de comparaison, la courbe a de la figure 4A est également reportée sur la figure 4C.

Dans la situation illustrée à la figure 4C, on comprendra donc que le temps $T_{from-pulse}$ pris par la tension induite de mouvement pour retomber à une amplitude nulle par rapport à sa valeur moyenne est en conséquence plus long par rapport à la situation illustrée à la figure 4A. L'intervalle de temps $T_{to-pulse}$ au terme duquel l'impulsion d'entretien suivante est générée restant fixe, l'impulsion d'entretien (22 dans la figure) est appliquée avec une légère erreur de phase (en avance) par rapport à l'extrema de la tension induite de mouvement comme on peut le constater en comparant la position dans le temps de l'impulsion d'entretien 22 par rapport à la courbe c* qui illustre l'évolution de la tension induite de mouvement dans l'éventualité où aucune impulsion n'est générée. Le bilan énergétique est, dans ce cas également, meilleur que dans le cas où les impulsions d'entretien sont générées périodiquement à des intervalles de temps fixes comme dans les solutions de l'art antérieur.

Si l'on compare le principe d'entraînement selon la présente invention au principe d'entraînement décrit dans la demande européenne EP 0 938 034 susmentionnée, on comprendra que la solution selon la présente invention est légèrement moins optimale du point de vue énergétique. Néanmoins, la solution selon la présente invention est plus robuste et plus stable en ce sens qu'il n'existe aucun risque que le dispositif vibrant soit entraîné à une fréquence erronée par rapport à sa fréquence propre d'oscillation réelle et que ce dispositif devienne en conséquence instable, risque qui peut éventuellement surgir avec un dispositif vibrant opérant selon la demande européenne susmentionnée.

L'intérêt particulier de la présente invention par rapport aux autres solutions de l'art antérieur, et notamment les solutions consistant à entraîner le dispositif vibrant à une fréquence fixe, réside dans le fait que la fréquence à laquelle sont générées les impulsions d'entretien varie en fonction des conditions au porter du dispositif par l'utilisateur.

Il convient de revenir sur la question de l'apparition des surtensions lors de l'interruption de chaque impulsion d'entretien. La constante de temps de ces surtensions est essentiellement déterminée par les caractéristiques de la bobine, et notamment de sa résistance électrique et de son inductance. L'apparition de chaque surtension conduit à deux passages successifs et relativement rapprochés dans le temps de la tension VB12 par sa valeur moyenne. Il convient ainsi préférablement de filtrer ces surtensions par des moyens adéquats, soit à l'entrée du comparateur 2 par un moyen de filtrage analogique adapté, ou, à la sortie du comparateur 2 par un moyen de filtrage digital, afin d'éviter que ces passages par la valeur moyenne dus à la surtension soient détecté comme les passages par la valeur moyenne désirés, c'est-à-dire les moments spécifiques qui déterminent la génération dans le temps des impulsions d'entretien.

Outre la solution analogique, une solution consiste par exemple à inhiber le comparateur 2 durant un intervalle de temps déterminé après l'interruption de l'impulsion d'entretien, intervalle de temps qui est choisi supérieur au temps durant lequel se produit la surtension.

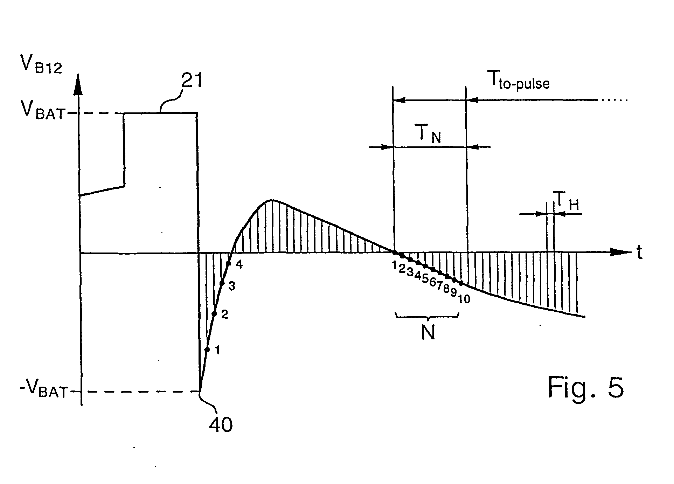

Selon une autre solution, pour effectuer un "filtrage digital" des surtensions, il convient par exemple avantageusement d'examiner plusieurs échantillons successifs du signal produit en sortie du comparateur 2. Sur la figure 5, il est illustré schématiquement la tension $V_{B12}$ présente aux bornes de la bobine et la surtension 40 apparaissant au terme de la génération de l'impulsion d'entretien 21. Comme illustré schématiquement, le signal est échantillonné à intervalles réguliers désignés $T_H$ de sorte qu'une série d'échantillons du signal est produite. On notera que l'échelle ainsi que le nombre d'échantillons sont présentés ici uniquement à titre d'exemple.

Plus particulièrement, au moment de la surtension 40, quatre échantillons dont la valeur est inférieure au niveau moyen de la tension induite de mouvement sont produits. Ces quatre échantillons sont désignés par les références 1 à 4. L'échantillon suivant le quatrième échantillon est supérieur au niveau moyen de la tension induite de mouvement. Suite au passage par le niveau moyen de la tension induite de mouvement, indiqué par la référence O, plus d'une dizaines d'échantillons dont la valeur est inférieure au niveau moyen de la tension induite de mouvement sont générés. A titre d'exemple, on a indiquée les dix premiers échantillons par les références 1 à 10. La situation est opposée dans le cas où l'on examine une surtension produite au terme d'une impulsion d'entretien de polarité négative.

Ainsi, en examinant un nombre N d'échantillons successifs (par exemple dix dans l'exemple schématique de la figure 5) et en vérifiant que ces dix échantillons successifs ont tous une valeur inférieure (ou supérieure dans le cas opposé) au niveau moyen de la tension induite de mouvement (dans l'exemple ce niveau moyen est nul), on peut clairement différencier une surtension d'un passage normal par le niveau moyen. Il convient ainsi de choisir un nombre N d'échantillons supérieur au nombre d'échantillons de valeur inférieure au niveau moyen produits suite à une surtension. Il convient d'autre part de considérer le délai occasionné lors de la détermination du passage par le niveau moyen O, c'est-à-dire le délai $T_N$ dont la valeur est égale à N fois la période d'échantillonnage $T_H$, et de déduire ce délai du temps $T_{\text{to-pulse}}$ jusqu'à la génération de l'impulsion d'entretien suivante défini dans l'expression (1) ci-dessus, comme cela est illustré schématiquement dans la figure 5.

On comprendra que diverses modifications et/ou améliorations évidentes pour l'homme du métier peuvent être apportées au procédé d'entraînement et au dispositif vibrant décrit dans la présente description sans sortir du cadre de l'invention défini par les revendications annexées. En particulier, on rappellera qu'il n'est a priori pas nécessaire d'effectuer une mesure préalable de la fréquence d'oscillation du dispositif vibrant et que les paramètres temporels définissant quand doivent être générées les impulsions d'entretien, à savoir notamment l'intervalle de temps $T_{\text{to-pulse}}$ peut être prédéterminé et fixé à une valeur nominale. La mesure préalable est néanmoins préférable en ce sens qu'on optimise le fonctionnement du dispositif vibrant en se situant au plus proche de la fréquence propre du dispositif vibrant au moment de son activation.

**Revendications**

1. Procédé d'entretien des oscillations d'un dispositif vibrant destiné à équiper une unité portée prés du corps, telle qu'une pièce d'horlogerie, comprenant un boîtier, une masse mobile à l'intérieur de ce boîtier destinée à lui transmettre des vibrations, une bobine (L) couplée électromagnétiquement à ladite masse mobile pour la faire osciller, et un circuit d'excitation de ladite bobine (L), ce procédé consistant à générer, au moyen dudit circuit d'excitation, un ensemble d'impulsions d'entretien (21, 22) de polarité alternée et de durée déterminée ($T_{\text{pulse}}$) coïncidant sensiblement avec les extrema de la tension induite de mouvement ($U_{\text{ind}}$, $V_{B12}$) produite aux bornes (B1, B2) de ladite bobine (L),
**caractérisé en ce que** chaque impulsion d'entretien (21, 22) est générée au terme d'un intervalle de temps prédéterminé et non-variable ($T_{\text{to-pulse}}$) considéré à partir d'un passage (O) par le niveau moyen de ladite tension induite de mouvement ($U_{\text{ind}}$, $V_{B12}$), l'intervalle de temps ($T_{\text{from-pulse}}$) pris par ladite tension induite de mouvement ($U_{\text{ind}}$, $V_{B12}$) pour atteindre ledit passage (O) par le niveau moyen au terme d'une impulsion d'entretien (21, 22) étant déterminé par la fréquence propre instantanée d'oscillation du dispositif vibrant, de sorte qu'une adaptation de la fréquence à laquelle sont générées lesdites impulsions d'entretien (21, 22) est opérée.

2. Procédé selon la revendication 1, **caractérisé en ce que** l'intervalle de temps prédéterminé et non-variable ($T_{\text{to-pulse}}$) est calculé à partir de la formule $T_{\text{to-pulse}} = T_O/4 - T_{\text{pulse}}/2$ dans laquelle $T_0$ est l'inverse de la fréquence propre.

3. Procédé selon les revendications 1 ou 2, **caractérisé en ce que**, lors d'une activation dudit dispositif vibrant ou à la suite d'une perturbation brutale subie par ladite unité portée près du corps, au moins une impulsion de démarrage (31, 32) est générée pour mettre en oscillation ledit dispositif vibrant.

4. Procédé selon la revendication 3, **caractérisé en ce que**, suite à la mise en oscillation forcée dudit dispositif vibrant, une mesure de la fréquence propre d'oscillation est effectuée de manière à fixer ledit intervalle de temps nonvariable ($T_{\text{to-pulse}}$) au terne duquel est générée chaque impulsion d'entretien (21, 22) à partir dudit passage (O) par le niveau moyen de la tension induite de mouvement.

5. Dispositif vibrant destiné à équiper une unité portée près du corps, telle qu'une pièce d'horlogerie, comprenant un boîtier, une masse mobile à l'intérieur de ce boîtier destinée à lui transmettre des vibrations, une bobine (L) couplée électromagnétiquement à ladite masse mobile pour la faire osciller, et un circuit d'excitation (1) de ladite bobine (L), ce circuit d'excitation étant agencé pour produire un ensemble d'impulsions d'entretien (21, 22) de polarité alternée et de durée déterminée ($T_{pulse}$) coïncidant sensiblement avec les extrema de la tension induite de mouvement ($U_{ind}$, $V_{B12}$) produite aux bornes (B1, B2) de ladite bobine (L),
**caractérisé en ce que** ledit circuit d'excitation (1) est agencé pour générer chaque impulsion d'entretien (21, 22) au terme d'un intervalle de temps prédéterminé et non-variable ($T_{to-pulse}$) considéré à partir d'un passage (O) par le niveau moyen de ladite tension induite de mouvement ($U_{ind}$, $V_{B12}$), l'intervalle de temps ($T_{from-pulse}$) pris par ladite tension induite de mouvement ($U_{ind}$, $V_{B12}$) pour atteindre ledit passage (O) par le niveau moyen au terme d'une impulsion d'entretien (21, 22) étant déterminé par la fréquence propre instantanée d'oscillation du dispositif vibrant, de sorte qu'une adaptation de la fréquence à laquelle sont générées lesdites impulsions d'entretien (21, 22) est opérée.

6. Dispositif selon la revendication 5, **caractérisé en ce que** l'intervalle de temps prédéterminé et non-variable ($T_{to-pulse}$) est calculé à partir de la formule $T_{to-pulse} = T_O/4 - T_{pulse}/2$ dans laquelle $T_0$ est l'inverse de la fréquence propre.

7. Dispositif selon les revendications 5 ou 6, **caractérisé en ce que** ledit circuit d'excitation (1) comprend :

   - un pont en H comprenant des première et seconde branches comprenant chacune une paire de transistors (Q1, Q2, Q3, Q4) connectés en série entre deux potentiels d'alimentation ($V_{BAT}$, $V_{SS}$), ladite bobine étant connectée par ses bornes (B1, B2) entre les noeuds de connexion des transistors de chaque branche;
   un comparateur (2) comprenant des première et seconde entrées connectées aux bornes (B1, B2) de ladite bobine (L) et destiné à amplifier la tension (VB12) aux bornes de ladite bobine (L); et
   - un circuit logique (3) permettant notamment de commander l'état des transistors (Q1, Q2, Q3, Q4) dudit pont en H de manière à appliquer alternativement une tension positive et négative aux bornes (B1, B2) de ladite bobine afin de générer lesdits impulsions d'entretien (21, 22).

8. Dispositif selon la revendication 7, **caractérisé en ce que** ledit circuit logique (3) permet en outre de générer, lors d'une activation dudit dispositif vibrant ou à la suite d'une perturbation brutale subie par ladite unité portée près du corps, au moins une impulsion de démarrage (31, 32) pour mettre en oscillation ledit dispositif vibrant.

9. Dispositif selon la revendication 8, **caractérisé en ce que** ledit circuit logique (3) permet en outre une mesure de la fréquence propre d'oscillation du dispositif vibrant de manière à fixer ledit intervalle de temps non-variable ($T_{to-pulse}$) au terme duquel est générée chaque impulsion d'entretien (21, 22) à partir dudit passage (O) par le niveau moyen de la tension induite de mouvement.

10. Dispositif selon la revendication 7, **caractérisé en ce que** ledit dispositif comprend en outre des moyens de filtrage pour filtrer une surtension (40) apparaissant au terme de la génération de chaque impulsion d'entretien (21, 22).

11. Dispositif selon la revendication 10, **caractérisé en ce que** le signal produit en sortie dudit comparateur (2) est échantillonné par ledit circuit logique (3) et **en ce que** lesdits moyens de filtrage comprennent des moyens pour examiner un nombre N d'échantillons successifs du signal, ce nombre N étant choisit de manière à permettre une différentiation entre ladite surtension (40) et ledit passage (O) par le niveau moyen de ladite tension induite de mouvement ($U_{ind}$, $V_{B12}$), un intervalle de temps ($T_N$) égal à N fois la période d'échantillonnage ($T_H$) étant déduit dudit intervalle de temps non-variable ($T_{to-pulse}$).

12. Dispositif selon la revendication 10, **caractérisé en ce que** lesdits moyens de filtrage comprennent des moyens pour inhiber la sortie dudit comparateur (2) durant un intervalle de temps déterminé supérieur à la durée de ladite surtension (4).

13. Dispositif selon l'une quelconque des revendications 7 à 12, **caractérisé en ce que** celui-ci comporte en outre un diviseur de tension enclenchable (4) permettant de fixer le potentiel de l'une des entrées dudit comparateur (2) à une tension déterminée ($V_{BAT}/2$) entre deux impulsions d'entretien successives (21, 22) lorsque le dispositif vibrant oscille librement afin de fixer le niveau moyen de ladite tension induite de mouvement ($U_{ind}$, $V_{B12}$) à cette tension déterminée ($V_{BAT}/2$).

**Claims**

1. Method for maintaining the oscillations of a vibrating device intended to be fitted to a unit worn close to the body, such as a timepiece, including a case, a moving mass inside said case intended to transmit vibrations thereto, a coil (L) electromagnetically coupled to said moving mass in order to make it oscillate, and an excitation circuit for exciting said coil (L), this method consisting in generating, by means of said excitation circuit, a set of driving pulses (21, 22) of alternate polarity and of determined duration ($T_{pulse}$) substantially coinciding with the extrema of the movement induced voltage ($U_{ind}$, $V_{B12}$) produced across the terminals (B1, B2) of said coil (L),
**characterised in that** each driving pulse (21, 22) is generated at the end of a predetermined and non-variable time interval ($T_{to-pulse}$) considered from a mean level crossing (O) of said movement induced voltage ($U_{ind}$, $V_{B12}$), the time interval ($T_{frm-pulse}$) taken by said movement induced voltage ($U_{ind}$, $V_{B12}$) to reach said mean level crossing (O) at the end of a driving pulse (21, 22) being determined by the instantaneous natural oscillation frequency of the vibrating device, such that an adaptation of the frequency at which said driving pulses (21, 22) are generated is carried out.

2. Method according to claim 1, **characterised in that** said predetermined and non-variable time interval ($T_{to-pulse}$) is calculated from the formula : $T_{to-pulse} = T_O/4 - T_{pulse}/2$, where $T_0$ is the inverse value of the natural frequency.

3. Method according to claim 1 or 2, **characterised in that**, when said vibrating device is activated or following an abrupt disturbance to said unit worn close to the body, at least one starting pulse (31, 32) is generated to cause said vibrating device to oscillate.

4. Method according to claim 3, **characterised in that**, following forced oscillation of said vibrating device, a natural oscillation frequency measurement is carried out so as to fix said non-variable time interval ($T_{to-pulse}$) at the end of which each driving pulse (21, 22) is generated from said mean level crossing (O) of the movement induced voltage.

5. Vibrating device intended to be fitted to a unit worn close to the body, such as a timepiece, including a case, a moving mass inside said case intended to transmit vibrations thereto, a coil (L) electromagnetically coupled to said moving mass in order to make it vibrate, and an excitation circuit (1) for exciting said coil (L), said excitation circuit being arranged to produce a set of driving pulses (21, 22) of alternate polarity and of determined duration ($T_{pulse}$) substantially coinciding with the extrema of the movement induced voltage ($U_{ind}$, $V_{B12}$) produced across the terminals (B1, B2) of said coil (L),
**characterised in that** said excitation circuit (1) is arranged to generate each driving pulse (21, 22) at the end of a predetermined and non-variable time interval ($T_{to-pulse}$) considered from a mean level crossing (O) of said movement induced voltage ($U_{ind}$, $V_{B12}$), the time interval ($T_{to-pulse}$) taken by said movement induced voltage ($U_{ind}$, $V_{B12}$) to reach said mean level crossing (O) at the end of a driving pulse (21, 22) being determined by the instantaneous natural oscillation frequency of the vibrating device, such that an adaptation of the frequency at which said driving pulses (21, 22) are generated is carried out.

6. Device according to claim 5, **characterised in that** said predetermined and non-variable time interval ($T_{to-pulse}$) is calculated from the formula : $T_{to-pulse} = T_O/4 - T_{pulse}/2$, where $T_0$ is the inverse value of the natural frequency.

7. Device according to claim 5 or 6, **characterised in that** said excitation circuit (1) includes:

   - an H bridge including first and second branches each including a pair of transistors (Q1, Q2, Q3, Q4) series connected between two supply potentials ($V_{BAT}$, $V_{SS}$), said coil being connected by its terminals (B1, B2) between the connection nodes of the transistors of each branch;
   - a comparator (2) including first and second inputs connected to the terminals (B1, B2) of said coil (L) and intended to amplify the voltage ($V_{B12}$) across the terminals of said coil (L); and
   - a logic circuit (3) particularly for controlling the state of the transistors (Q1, Q2, Q3, Q4) of said H bridge so as to apply alternately a positive and negative voltage across the terminals (B1, B2) of said coil in order to generate said driving pulses (21, 22).

8. Device according to claim 7, **characterised in that** said logic circuit (3) further allows at least one starting pulse (31, 32) to be generated, when said vibrating device is activated or following an abrupt disturbance to said unit worn close to the body, in order to make said vibrating device oscillate.

9. Device according to claim 8, **characterised in that** said logic circuit (3) further allows a measurement of the natural oscillation frequency of the vibrating device so as to fix said non-variable time interval ($T_{to-pulse}$) at the end of which each driving pulse (21, 22) is generated from said mean level crossing (O) of the movement induced voltage.

10. Device according to claim 7, **characterised in that** said device further includes filtering means for filtering an overvoltage (40) appearing at the end of the generation of each driving pulse (21, 22).

11. Device according to claim 10, **characterised in that** the signal generated at the output of said comparator (2) is sampled by said logic circuit (3) and **in that** said filtering means include means for examining a number N of successive samples of the signal, this number N being selected so as to allow a differentiation between said overvoltage (40) and said mean level crossing (O) of said movement induced voltage ($U_{ind}$, $V_{B12}$), a time interval ($T_N$) equal to N times the sampling period ($T_H$) being subtracted from said non-variable time interval ($T_{to-pulse}$).

12. Device according to claim 10, **characterised in that** said filtering means include means for inhibiting the output of said comparator (2) during a determined time interval greater than the duration of said overvoltage (40).

13. Device according to any of claims 7 to 12, **characterised in that** this device further includes a voltage divider (4) able to be switched on, for fixing the potential of one of the inputs of said comparator (2) at a determined voltage ($V_{BAT}/2$) between two successive driving pulses (21, 22) when the vibrating device is oscillating freely in order to fix the mean level of said movement induced voltage ($U_{ind}$, $V_{B12}$) at this determined voltage ($V_{BAT}/2$).

### Patentansprüche

1. Verfahren zur Aufrechterhaltung von Oszillationen einer Vibrationseinrichtung zur Ausstattung einer nah am Körper zu tragenden portablen Einheit, wie zum Beispiel einer Uhr, umfassend ein Gehäuse, eine im Inneren des Gehäuses angeordnete mobile Masse, die dazu ausgebildet ist, sich in Vibration zu versetzen, eine Spule (L), die mit der mobilen Masse elektromagnetisch gekoppelt ist, um diese in Oszillation zu versetzen und eine Anregungsschaltung der Spule (L), wobei das Verfahren mittels der Anregungsschaltung zur Erzeugung einer Reihe von Aufrechterhaltungsimpulsen (21, 22) ausgebildet ist, die alternierende Polarität und eine vorgegebene Zeitdauer ($T_{Pulse}$) aufweisen, die die im Wesentlichen mit den Extrema einer induzierten Spannung der Bewegung ($U_{ind}$, $V_{B12}$) zusammenfällt, die an den Kontakten (B1, B2) der Spule (L) erzeugt werden, **dadurch gekennzeichnet, dass** jeder Aufrechterhaltungspuls (21, 22) am Ende eines vorgegebenen und nicht variablen, vom Nulldurchgang (O) der induzierten Spannung der Bewegung ($U_{ind}$, $V_{B12}$) ausgehenden Zeitintervalls ($T_{to-pulse}$) erzeugt wird, das Zeitintervall ($T_{from-pulse}$), welches vom Ende eines Aufrechterhaltungspulses (21, 22) bis zum Nulldurchgang (O) der induzierten Spannung der Bewegung ($U_{ind}$, $V_{B12}$) genommen wird durch die instantane Eigenfrequenz der Oszillation der Vibrationseinrichtung derart bestimmt wird, dass eine Anpassung der Frequenz nach welcher die Aufrechterhaltungsimpulse (21, 22) erzeugt werden erfolgt.

2. Verfahren nach Anspruch 1, **dadurch gekennzeichnet, dass** das vorgegebene und nicht variable Zeitintervall ($T_{to-pulse}$) durch die Formel berechnet wird $T_{to-pulse} = T_{O/4} - T_{pulse}/2$ wobei $T_o$ die Inverse der Eigenfrequenz ist.

3. Verfahren nach Anspruch 1 oder 2, **dadurch gekennzeichnet, dass** während einer Aktivierung der Vibrationseinrichtung oder infolge einer brachialen, auf die am Körper tragbare portable Einheit einwirkenden Störung, wenigstens ein Startimpuls (31, 32) erzeugt wird, um die Vibrationseinrichtung in Oszillation zu versetzen.

4. Verfahren nach Anspruch 3, **dadurch gekennzeichnet, dass** unmittelbar nach einer erzwungenen Oszillationsanregung der Oszillationseinrichtung eine Messung der Eigenfrequenz derart durchgeführt wird, um das nichtvariable Zeitintervall (Tto-pulse) zu fixieren, an dessen Ende (21, 22) ausgehend zum Nulldurchgang (O) der induzierten Spannung der Bewegung jeder Aufrechterhaltungsimpuls erzeugt wird.

5. Vibrationseinrichtung, dazu ausgebildet, eine am Körper zu tragende portable Einheit, wie etwa eine Uhr, auszustatten, umfassend ein Gehäuse, eine im Inneren des Gehäuses angeordnete mobile Masse, die dazu ausgebildet ist, sich in Vibration zu versetzen, eine Spule (L), die mit der mobilen Masse elektromagnetisch gekoppelt ist, um diese in Oszillation zu versetzen und eine Anregungsschaltung (1) der Spule (L), wobei die Anregungsschaltung zur Erzeugung einer Reihe von Aufrechterhaltungsimpulsen (21, 22) ausgebildet ist, die alternierende Polarität und eine vorgegebene Zeitdauer (TPulse) aufweisen, die die im Wesentlichen mit den Extrema einer induzierten Spannung der Bewegung (Uind, VB12) zusammenfällt, die an den Kontakten (B1, B2) der Spule (L) erzeugt werden, **dadurch gekennzeichnet, dass** die Anregungsschaltung (1) zur Erzeugung jedes Aufrechterhaltungspulses (21, 22) am Ende eines vorgegebenen und nicht variablen, vom Nulldurchgang (O) der induzierten Spannung der Bewegung (Uind, VB12) ausgehenden Zeitintervalls (Tto-pulse) ausgebildet ist, das Zeitintervall (Tfrompulse), welches vom Ende eines Aufrechterhaltungspulses (21, 22) bis zum Nulldurchgang (O) der induzierten Spannung der Bewegung (Uind, VB12) genommen wird durch die instantane Eigenfrequenz der Oszillation der Vibrationseinrichtung derart bestimmt wird, dass eine Anpassung der Frequenz

6. Vorrichtung nach Anspruch 5, **dadurch gekennzeichnet, dass** das vorgegebene und nicht variable Zeitintervall (Tto-pulse) durch die Formel berechnet wird Tto-pulse = To/4 - Tpulse/2 wobei To die Inverse der Eigenfrequenz ist.

7. Einrichtung nach einem der Ansprüche 5 oder 6, **dadurch gekennzeichnet, dass** die Anregungsschaltung Folgendes aufweist:

   - eine H-Brückenschaltung, die erste und zweite Zweige aufweist, von denen jeder ein Paar Transistoren (Qa1, Q2, Q3, Q4) aufweist, die in Serie zwischen zwei Versorgungspotenzialen (VBAT, VSS) verbunden sind, wobei die Spule mit ihren Kontakten (B1, B2) zwischen Verbindungsknoten der Transistoren eines jeden Zweigs kontaktiert ist;
   - einen Komparator (2), der erste und zweite Eingänge aufweist, die mit den Kontakten (B1, B2) der Spule (L) kontaktiert ist und der dazu ausgebildet ist, die Spannung (VB12) an den Kontakten der Spule (L) zu verstärken; und
   - eine logische Schaltung (3), die es insbesondere erlaubt, den Zustand der Transistoren (Q1, Q2, Q3, Q4) der H-Brückenschaltung derart zu kontrollieren, um abwechselnd eine positive und negative Spannung an den Kontakten (B1, B2) der Spule zu erzeugen, um die Aufrechterhaltungsimpulse (21, 22) zu generieren.

8. Einrichtung nach Anspruch 7, **dadurch gekennzeichnet, dass** die Logikschaltung (3) es unter anderem erlaubt, bei einer Aktivierung der Vibrationseinrichtung oder infolge einer auf die nah am Körper zu tragende tragbare Einheit einwirkenden brachialen Störung, wenigstens einen Startimpuls (31, 32) zu erzeugen, um die Oszillationseinrichtung in Oszillation zu versetzen.

9. Einrichtung nach Anspruch 8, **dadurch gekennzeichnet, dass** die logische Schaltung (3) unter anderem eine Messung der Eigenfrequenz der Vibrationseinrichtung derart ermöglicht, um das nichtvariable Zeitintervall (Tto-pulse) zu fixieren, an dessen Ende (21, 22) ausgehend zum Nulldurchgang (O) der induzierten Spannung der Bewegung jeder Aufrechterhaltungsimpuls (21, 22) erzeugt wird.

10. Einrichtung nach Anspruch 7, **dadurch gekennzeichnet, dass** die Einrichtung unter anderem Filtermittel aufweist, um eine Überspannung (40) zu filtern, die am Ende einer Erzeugung eines jeden Aufrechterhaltungsimpulses (21, 22) entsteht.

11. Einrichtung nach Anspruch 10, **dadurch gekennzeichnet, dass** das am Ausgang des Komparators (2) erzeugte Signal von der logischen Schaltung (3) ausgewählt ist und wobei die Filtermittel Mittel zum Untersuchen einer Anzahl N von sukzessiven Proben des Signals aufweist, wobei die Zahl N derart gewählt wird, um zwischen der Überspannung (40) und dem Nulldurchgangs (O) der induzierten Spannung der Bewegung (Uind, VB12) zu differenzieren, wobei ein Zeitintervall (TN) gleich dem N-Fachen der Auswahlzeit (TH) ist, die während dem nichtvariablen Zeitintervall (Tto-pulse) vergeht.

12. Einrichtung nach Anspruch 10, **dadurch gekennzeichnet, dass** die Filtermittel Mittel zum Unterdrücken des Ausgangs des Komparators für die Dauer eines Zeitintervalls haben, welches länger als die Dauer der Überspannung (4) ist.

13. Einrichtung nach einem der vorhergehenden Ansprüche 7 bis 12, **dadurch gekennzeichnet, dass** diese unter anderem einen Kerb-Spannungsteiler (4) aufweist, der es erlaubt, das Potenzial eines Eingangs des Komparators (2) auf einer vorgegebene Spannung ($V_{BAT}/2$) zwischen zwei sukzessiven Aufrechterhaltungsimpulsen zu fixieren (21, 22), wenn die Vibrationseinrichtung vor einem Fixieren des Nulldurchgangs der induzierten Spannung der Bewegung ($U_{ind}$, $V_{B12}$) zu dieser bestimmten Spannung ($V_{BAT}/2$) frei oszilliert.

Fig. 1

EP 1 342 132 B1

$U_{ind}$

$V_{BAT}/2$

T

t

Impulsions
d'entretien

$V_{BAT}$

21

t

$-V_{BAT}$

22

$T_{pulse}$

$T^*$

## Fig. 2

$V_{B12}$

Démarrage

Mesure de
fréquence

Phase d'entretien de
l'oscillation

$V_{BAT}$

31

21

$V_{BAT}/2$

$T_0$

t

$-V_{BAT}$

32

22

40

## Fig. 3

14

Fig. 4A

Fig. 4B

Fig. 4C

Fig. 5

## RÉFÉRENCES CITÉES DANS LA DESCRIPTION

### Documents brevets cités dans la description

- EP 0710899 A
- EP 0884663 A
- EP 0625738 A

- US 5436622 A
- EP 0938034 A